# EUROPEAN PATENT APPLICATION

(11) **EP 4 580 346 A1**
(43) Date of publication of application: **02.07.2025**
(21) Application number: 24222068.9
(22) Date of filing: 20.12.2024
(51) Int. Cl.: H10D 89/10, H10D 84/01, H01L 23/528

(54) **DOUBLE-SIDED DEVICE CONTACTS AND THROUGH VIAS FOR PERFORMANCE AND LAYOUT BENEFITS**

(30) Priority: 29.12.2023 US 202318400736
(71) Applicant: INTEL Corporation, Santa Clara, CA 95054 (US)
(72) Inventor: NATARAJAN, Sanjay, Hillsboro, OR 97124 (US); KOBRINSKY, Mauro, Portland, OR 97229 (US); WEBER, Cory, Hillsboro, OR 97124 (US); TIWARI, Vishal, Hillsboro, OR 97123 (US); MILLS, Shaun, Hillsboro, OR 97123 (US); D'SILVA, Joseph, Hillsboro, OR 97124 (US); MANNEBACH, Ehren, Beaverton, OR 97007 (US)
(74) Representative: 2SPL Patentanwälte PartG mbB

(57) **Abstract**

An integrated circuit (IC) device includes transistors between front- and back-side interconnect layers and having source and/or drain regions with front- and back-side contacts. The transistors may be between isolation structures on a same pitch as the transistor gates, sources, and drains. Via structures adjacent to the transistors couple between the front- and back-side interconnect layers. The transistors and isolation and via structures may be utilized in various logic cells. Transistors having front- and back-side source and/or drain contacts may include vias through or alongside the source and/or drain regions.

## Description

### BACKGROUND

Various approaches are typically used to increase intrinsic integrated circuit (IC) device drive current, e.g., drive current for a given transistor channel width, including reducing epi contact resistance (including by shaping the metal-epi interface geometry), increasing channel mobility, increasing epi conductance, etc. These and other approaches are being explored and deployed, yet there is need for additional performance improvements.

Many solutions may provide performance benefits, but are accompanied by disruptions in design or layout flexibility. Structures and methods are needed to improve IC device drive currents which are conveniently integrated into existing design and layout schemes.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIGS. 1A, 1B, and 1C illustrate cross-sectional profile views of integrated circuit (IC) devices having transistor structures with front- and back-side contacts on drain and source regions, in accordance with some embodiments;
FIGS. 2A and 2B illustrate cross-sectional profile and plan views of a via structure between and coupling interconnect layers and between adjacent logic cells, in accordance with some embodiments;
FIGS. 3A, 3B, 3C, and 3D illustrate cross-sectional profile and plan views of logic cells between via structures, which are between and coupling interconnect layers, in accordance with some embodiments;
FIGS. 4A, 4B, 4C, 4D, and 4E illustrate cross-sectional profile and plan views of transistor structures having via structures through or alongside drain or source regions, in accordance with some embodiments;
FIG. 5 is a flow chart of methods for forming an IC device having front- and back-side interconnects and contacts to a transistor, in accordance with some embodiments;
FIG. 6 illustrates a cross-sectional profile view of an IC system having front- and back-side contacts and via structures between interconnect layers, in accordance with some embodiments;
FIG. 7 illustrates a diagram of an example data server machine employing an IC device having logic cells between front- and back-side interconnect layers and with front- and back-side contacts, in accordance with some embodiments; and
FIG. 8 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Structures, and techniques are described to improve the performance of integrated circuit (IC) devices with transistors between front- and back-side interconnect layers. Transistor structures are described with doubled contact area and a resultant 50% reduction in contact resistance, which is enabled by backside power delivery and back-side contacts. The contact resistance to the diffusion of devices is reduced by contacting source and drain regions from both the top (as is standard) and bottom, which is available via back-side power delivery and contacts. Reduced contact resistance provides improved device performance by providing increased drive current and so increased operating speeds. This reduction in contact resistance provides a significant improvement (e.g., of a few percentage points) in device operating frequency.

Improved (e.g., reduced) source and/or drain contact resistance(s) are most effectively utilized with short parallel branches in and between front- and back-side layers. For example, minimally differing electrical lengths between parallel branches and low-resistance branches between pairs of front- and back-side contacts are provided by through-vias near transistors having front- and back-side contacts, e.g., within logic cells including the transistors. Through-vias between front- and back-side interconnect layers may be implemented in compact cells using consistent, minimum pitches for transistor (e.g., gate, source, drain) structures, as well as for isolation and via structures. Such consistent, minimum pitches and multiple options of via implementations enable compact logic cells and design and layout flexibility.

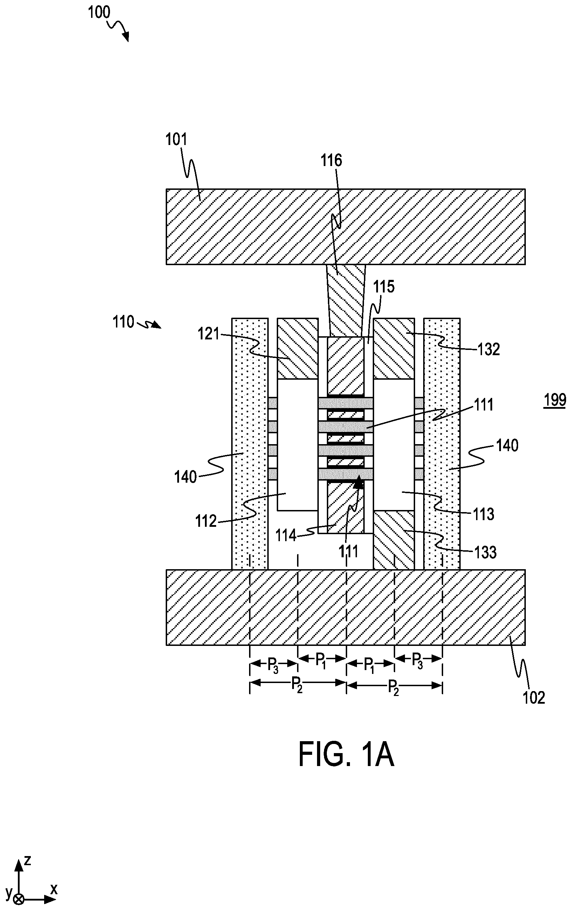

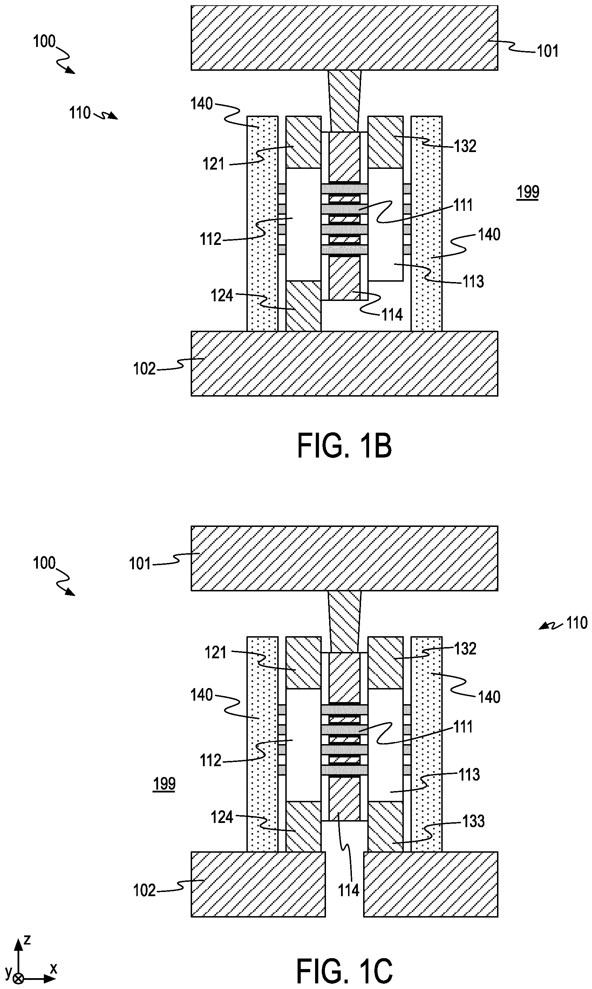

FIGS. 1A, 1B, and 1C illustrate cross-sectional profile views of IC devices 100 having transistor structures 110 with front- and back-side contacts on drain and source regions 112, 113, in accordance with some embodiments. Transistor structures 110 are contacted above and below at one or both of drain and source regions 112, 113, which reduces contact resistance and enables significant increases in drive current, e.g., without the need to improve channel structures or materials. Upper contacts 121, 132 may be conveniently coupled to a first (e.g., front-side) interconnect layer 101. Lower contact 133 may be conveniently coupled to a second (e.g., back-side) interconnect layer 102. Isolation structures 140 are adjacent drain and source regions 112, 113 at a tight pitch than enables compact packing of transistor structures 110 in existing layout schemes, for example, in logic cells with small footprints that enable area conservation.

FIG. 1A shows transistor 110 between first and second interconnect layers 101, 102. Transistor structure 110 includes a channel region 111 between drain and source regions 112, 113. Drain region 112 is coupled by drain contact 121 to interconnect layer 101 over transistor structure 110. Source region 113 is coupled by source contact 132 to interconnect layer 101 over transistor structure 110. Source region 113 is coupled by lower source contact 133 to interconnect layer 102 under transistor structure 110.

Interconnect layers 101, 102 are first and second metallization layers in first and second metallization networks. Layers 101, 102 may be the layers nearest a device layer having transistor structure 110 in an array of transistor structures 110. For example, layer 101 or 102 may be a metal 0 (M0 or met0) layer in an interconnect network over transistor structure 110 (and other structures 110 in a device layer between layers 101, 102). Likewise, the layer 102 or 101 opposite a M0 layer (on the other or under side of structure 110) may be a backmetal 0 (BM0) layer in an interconnect network under transistor structure 110. Metallization layers 101, 102 may include metal lines (e.g., formed as trenches) through one or more dielectric materials isolating adjacent metallization structures. Metallization layers 101, 102 may include metal vias coupling to metal lines and vias in other metallization layers.

In many embodiments, layers 101, 102 are front- and back-side layers, respectively. For example, front-side layer 101 may be built up over transistor structure 110 on a front side of a substrate 199, and other front-side interconnect layers (e.g., of metal lines and vias) may be built up over layer 101 in a metallization network of interconnections. Back-side layer 102 under transistor structure 110 may be built up over transistor structure 110 on a back side of substrate 199 after reversing or inverting substrate 199, and other back-side interconnect layers may be built up over layer 102. Layers 101, 102 may be referred to as front- and back-side layers in the context of certain illustrated embodiments, but these exemplary embodiments are not limiting. A back-side interconnect network may have thicker lines and vias and be dedicated mostly to power delivery, while a front-side interconnect network may be dedicated to signal routing.

Metallization layers 101, 102 may be formed by any suitable means and may include any suitable materials. In many embodiments, layers 101, 102 are in interconnect structures having one or more of copper, gold, tantalum, cobalt, tungsten, ruthenium, molybdenum, aluminum, and nickel, including in alloys, and layers 101, 102 may include any of these or other metals. In some embodiments, layers 101, 102 include nitrides of metals, e.g., tantalum and titanium. Layers 101, 102 may include other electrically conductive materials, including non-metals. One or both of layers 101 may be built up in a back-end-of-line (BEOL) process. Although layers 101, 102 may be BEOL, front- and back-side layers 101, 102 in some exemplary embodiments, other means of forming layers 101, 102 may be utilized.

The conductive materials of interconnect layers 101, 102 are separated by suitable isolation materials, such as low-permittivity ("low-K") dielectric materials. In many embodiments, interconnect layers 101, 102 include oxides, nitrides, oxynitrides, etc. (for example, of silicon), through which metal lines and vias extend across and between layers. In many embodiments, metal lines and vias are formed by a damascene, dual-damascene, etc. Metal lines and vias in layers 101, 102 may include a bulk metal in a barrier or liner metal.

Contacts 121, 132, 133 are metal structures that couple transistor structure 110 to interconnect layers 101, 102. Drain contact 121 contacts drain region 112. Source region 113 is between and contacts contacts 132, 133. Front-side or upper contacts 121, 132 are coupled to upper layer 101, and back-side or lower contact 133 is coupled to lower layer 102. Drain and source contacts 121, 132, 133 couple regions 112, 113 to corresponding layers 101, 102. Front-side contacts 121, 132 couple regions 112, 113, respectively, to front-side interconnect layer 101. Back-side contact 133 couples source region 113, to back-side interconnect layer 102.

In some embodiments, additional metallization structures (not shown) couple contacts 121, 132 to layer 101. For example, drain and source contact vias similar to gate via 116 may couple with contacts 121, 132 and layer 101 in a plane behind or in front of the viewing plane of FIG. 1A. In some embodiments, contacts 121, 132 directly contact layer 101, e.g., much like contact 133 couples source region 113 to interconnect layer 102. In some embodiments, one or more additional metallization structures (not shown) are between contact 133 and layer 102, and the structure(s) couple contact 133 to layer 102.

In many embodiments, transistor structures 110 are symmetrical about channel regions 111 and gate structure 114, and drain and source regions 112, 113 may be reversed interchangeably. However, the identification of region 113 as the source of charge carriers entering channel region 111 may be key in some embodiments due to the electrical relationships of transistor structure 110 and source region 113 to other components in a given circuit. Having two contacts 132, 133 coupling source region 113 to a voltage source (e.g., through interconnect layers 101, 102) reduces the corresponding source contact resistance. Reduced source resistance may advantageously reduce the voltage drop across the source resistance and increase the gate-source voltage. This increased gate-source voltage and a correspondingly higher overdrive over the voltage threshold V_{TH} may increase the conductance of transistor structure 110 and result in a higher drive current without changing channel dimensions, materials, etc.

Drain and source structures or regions 112, 113 are regions of semiconductor material doped with impurities, e.g., having increased charge-carrier availabilities and associated conductivities. Drain and source regions 112, 113 are electrically and physically coupled to opposite ends of channel regions 111. In the illustrated embodiment, regions 112, 113 include faceted epitaxial material that has been grown, for example, laterally from an end portion of channel regions 111. Drain and source regions 112, 113 may be polycrystalline or substantially monocrystalline, e.g., having long-range order at least adjacent ends of channel regions 111 and merging or joining into a unitary body with few grain boundaries. Regions 112, 113 may be formed by any suitable method, e.g., from sub-channel material. Impurity-doped regions 112, 113 need not be epitaxial material, e.g., with facets. Each of regions 112, 113 may include multiple impurity-doped structures, which may be merged into a unitary body on each end of channel regions 111. Regions 112, 113 may include one or more electrically active impurities in a Group IV semiconductor material (e.g., Si, Ge, SiGe, GeSn alloy). Drain and source regions 112, 113 may be doped of an opposite type (e.g., n- or p-type) or of similar type to channel region 111. Drain and source regions 112, 113 may include a predominant semiconductor material, and one or more n-dopants (such as phosphorus, arsenic, or antimony) or p-type impurities (such as boron or aluminum).

Transistor structure 110 includes channel region 111 between (and coupling) source and drain regions 112, 113. Channel region 111 may be or include any suitable structure(s) or material(s). Channel region 111 advantageously includes monocrystalline semiconductor. Channel region 111 may include a two-dimensional (2D) material or other deposited semiconductor film. Channel region 111 may be doped of an opposite type (e.g., n- or p-type) or of similar type to drain and source regions 112, 113. As shown, channel region 111 between source and drain regions 112, 113 may be in multiple nanoribbons, nanowires, nanosheets, etc., but other structures may be utilized. In some embodiments, channel region 111 is in a semiconductor fin between source and drain regions 112, 113.

Transistor structure 110 includes gate structure 114 adjacent channel region 111. Gate structure 114 includes at least a gate electrode and a gate dielectric over channel region 111. The gate electrode may include one or more gate metals, such as a liner metal and a bulk metal enclose by the liner metal. A gate metal liner may include multiple layers of liner metal, and a bulk metal may also include multiple metals. Gate metal(s) may be chosen due to a metal workfunction, which may have an effect on a transistor voltage threshold V_{TH}. A gate via 116 may contact gate structure 114 (e.g., at a gate metal electrode) and couple gate structure 114 to layer 101 (or 102). Similar vias (not shown) may contact and couple contacts 121, 132 to upper layer 101. For example, vias coupling contacts 121, 132 to upper layer 101 may be just in front of or behind the viewing plane of FIG. 1A.

Gate structure 114 includes a gate dielectric between channel region 111 and a gate metal, e.g., to provide electrical insulation between channel region 111 and the gate electrode and to control conductance of transistor structure 110. A gate dielectric may have more than one layer and may be of any suitable material(s). The one or more layers of gate dielectric may include a silicon oxide, silicon dioxide (SiO₂), a silicon oxynitride, etc. Advantageously, gate dielectric includes a high-permittivity ("high-K") dielectric, which may improve transconductance. For example, a high-K (or high-dielectric constant) dielectric may result in increased conductance of transistor structure 110 (through channel region 111) for a given gate bias.

Gate spacers 115 are between gate structure 114 and drain and source regions 112, 113. Gate spacers 115 are electrically insulating materials, such as low-K dielectrics (e.g., silicon dioxide (SiO₂), etc.), that insulate gate structure 114 from drain and source regions 112, 113.

Isolation structures 140 are adjacent and substantially parallel to both of drain and source regions 112, 113. Isolation structures 140 also include electrically insulating materials, such as low-K dielectrics, that isolate transistor structure 110 from adjacent structures. Isolation structures 140 may be between, and isolate, adjacent transistor structures 110. For example, isolation structures 140 may be electrical insulators between collinear channel regions 111 in adjacent transistor structures 110. In some such embodiments, isolation structures 140 provide electrical isolation in interruptions or breaks between collinear channel regions 111. For example, though absent at isolation structures 140, the nanoribbons of channel region 111 may continue to both sides (e.g., in the x-directions) of transistor structure 110 and isolation structures 140. In other embodiments, the nanoribbons terminate at isolation structures 140. Isolation structures 140 extend vertically (e.g., in the z direction) to a first height above an upper surface of drain and source regions 112, 113 and to a second height below a lower surface of drain and source regions 112, 113. In some embodiments, isolation structures 140 extend vertically to a first height at or above an upper surface of contacts 121, 132 and to a second height at or below a lower surface of lower contact 133.

A pitch P₁ is between gate structure 114 and each of drain and source regions 112, 113. As used herein, a pitch between features is the dimension separating and perpendicular to the centerlines of the features. A pitch P₂ is between gate structure 114 and each of isolation structures 140. A pitch P₃ is between each of drain and source regions 112, 113 and a nearest of the isolation structures 140. In some embodiments, pitch P₁ between gate structure 114 and each of drain and source regions 112, 113 is advantageously equal to pitch P₃ between each of drain and source regions 112, 113 and the nearest isolation structure 140. In such embodiments, pitches P₁, P₃ are equal to half of pitch P₂, and pitch P₂ between gate structure 114 and each of isolation structures 140 is equal to pitch P₂ between drain and source regions 112, 113. Such constancy of pitches P₁, P₃ may advantageously enable a consistent (e.g., minimum) spacing in an array of transistor structures 110. Such consistent, minimum spacing may allow a layout array or scheme to be maintained, even with isolation structures 140 placed between adjacent transistor structures 110. Consequently, the consistent, minimum spacing may maximize a density of transistor structures 110 in such an array. In other embodiments, pitch P₃ is greater than pitch P₁, e.g., to allow for more isolation (such as low-K dielectric material) between adjacent transistor structures 110.

Substrate 199 may include any suitable material or materials, for example, metals and dielectrics in interconnect layers 101, 102 and one or more layers of semiconductor material between layers 101, 102. In some examples, substrate 199 includes monocrystalline silicon (including silicon on insulator (SOI)), polycrystalline silicon, germanium, silicon germanium, a III-V alloy material (e.g., gallium arsenide), a silicon carbide (e.g., SiC), a sapphire (e.g., Al₂O₃), or any combination thereof. Substrate 199 may also include semiconductor materials, metals, dielectrics, dopants, and other materials commonly found in semiconductor substrates. In some embodiments, substrate 199 and IC device 100 are coupled to another substrate (not shown), such as a package substrate, interposer, or other host component. Interconnect layers 101, 102 may be coupled (e.g., through respective interconnect, metallization networks) through the other (not-shown) substrate to a power supply (such as a battery, switched power supply, etc.).

FIGS. 1B and 1C illustrate other embodiments having front- and back-side contacts 121, 132, 124. FIG. 1B shows transistor structure 110 with a back-side drain contact 124. Drain region 112 is between and in contact with contacts 121, 124. Drain contact 124 contacts drain region 112 and couples drain region 112 and back-side interconnect layer 102. Front-side contacts 121, 132 contact and couple drain and source regions 112, 113, respectively. Front-side contacts 121, 132 couple drain and source regions 112, 113, respectively, to front-side interconnect layer 101.

In many embodiments, source contact resistance is more critical than drain contact resistance, e.g., due to the effect of any source resistance on the gate-source voltage (and its overdrive relative to voltage threshold V_{TH}, which may control the conductance of transistor structure 110). In some embodiments, there is a small capacitance penalty associated with double-sided contacts (i.e., having contacts on both front and back sides), for example, due to the added source or drain metallization adjacent the gate metal of gate structure 114. Consequently, an added backside contact 133 on source region 113 may be preferred over a backside contact 124 on drain region 112. However, in some embodiments, backside contact 124 is deployed (and backside contact 133 is not deployed), e.g., due to any of various electrical or layout constraints, such as conductive structures adjacent source region 113, etc.

FIG. 1C illustrates transistor 110 having both front-side contacts 121, 132 and both back-side contacts 124, 133. Having both front- and back-side contacts 121, 124, 132, 133 may minimize transistor contact resistances. In some embodiments, the capacitance penalty associated with deploying all of contacts 121, 124, 132, 133 may be minimized by staggering at least back-side contacts 124, 133, and/or minimizing a gate profile adjacent and parallel to contacts 124, 133 adjacent layer 102.

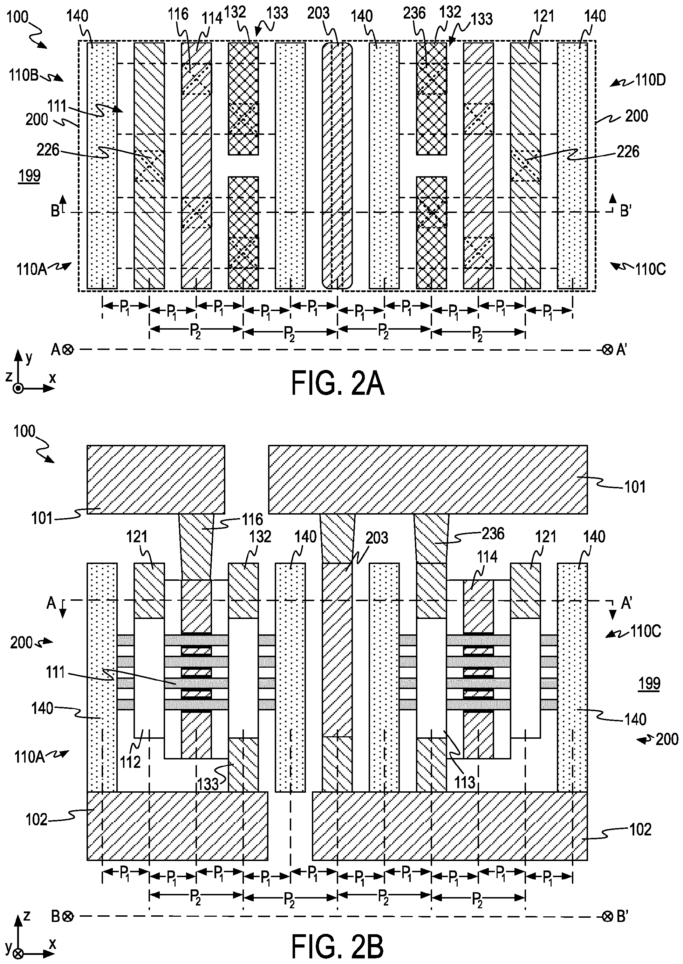

FIGS. 2A and 2B illustrate cross-sectional profile and plan views of a via structure 203 between adjacent logic cells 200 and between and coupling interconnect layers 101, 102, in accordance with some embodiments. Dashed lines delineate cells 200 to each include multiple transistor structures 110 on either side of shared via structure 203. Isolation structures 140 are between transistor structures 110 and via structure 203. Dashed lines are also used to show, e.g., for illustrative purposes, features above viewing plane A-A' in FIG. 2A (such as vias 116, 226, 236 and the nanoribbons of channel regions 111). Dashed lines also show the locations of viewing plane B-B' (of FIG. 2B) in FIG. 2A and viewing plane A-A' (of FIG. 2A) in FIG. 2B. In the exemplary embodiments of FIGS. 2A, 2B, cells 200 are inverters, but other logic cells may have similar or different layouts and may include any suitable number of transistor structures 110. For example, a NAND (i.e., "NOT AND") logic cell 200 may include four or more transistor structures 110, e.g., with two parallel transistor structures 110 pulling an output high (e.g., pulling connected drain regions 112 to a first voltage source Vcc) if provided a low input (e.g., at connected gate structures 114) and two other series transistor structures 110 together pulling an output low (e.g., to a second voltage source Vss) if provided a high input. More complex (e.g., having more inputs or more parallel legs) logic cells 200 may be deployed.

Via structure 203 couples interconnect layers 101, 102 and may provide beneficially short electrical paths between front- and back-side contacts 132, 133 (or 121 and 124). Short electrical paths between contacts 132, 133 (or 121 and 124) advantageously provide for low-resistance source (or drain) paths, and correspondingly short electrical lengths between contacts 132, 133 (or 121 and 124) to a same region 113 (or 112) may ensure no significant voltage mismatch between top and bottom connections. Consistent (e.g., minimum) spacing of via structure 203 and isolation structures 140, e.g., on pitches P₁, P₂, may enable the maintaining of layout arrays across many cells, the minimizing of the area costs spent on those cells, and the maximizing of a density of transistor structures 110 in IC device 100.

FIG. 2A shows a plan view of multiple cells 200 each having multiple transistor structures 110 adjacent and between isolation structures 140. For example, transistor structures 110A, 110B are adjacent and between isolation structures 140 in an inverter cell 200. Cells 200 are vertically between (e.g., in the z-direction) front- and back-side interconnect networks (not shown in FIG. 2A). Gate electrode (of gate structures 114) of transistor structures 110A, 110B are coupled and may receive an input signal to cell 200. (Although shown as a single, integrated gate structure 114, transistor structures 110A, 110B may have distinct gate structures 114 (e.g., below viewing plane A-A') that are contacted and coupled, e.g., at viewing plane A-A'.) Source regions (under contacts 132, over contacts 133) of both transistor structures 110A, 110B are both coupled (through contacts 132, 133) to metallization layers 101, 102 and to separate voltage sources through layers 101, 102. For example, source region of transistor structure 110B is coupled to a first voltage source Vcc through contacts 132, 133 and both layers 101, 102, and source region of transistor structure 110A is coupled to a second voltage source Vss through contacts 132, 133 and both layers 101, 102. Source contacts 132 are crosshatched in FIG. 2A to indicate source regions are contacted both above and below viewing plane A-A' by front- and back-side contacts 132, 133, respectively. (Although coupled by a single, integrated front-side contact 121, transistor structures 110A, 110B may have distinct drain regions or structures that are contacted and coupled at least at viewing plane A-A' by contact 121.)

FIG. 2B illustrates a cross-sectional profile view of cells 200 on either side of via structure 203, each having transistor structures 110 adjacent and between isolation structures 140. Via structure 203 extends vertically (e.g., in the z direction) between first and second metallization layers 101, 102. Via structure 203 includes a metallic material (such as any of the example described at FIG. 1A for layers 101, 102). As illustrated in FIG. 2B, via structure 203 may include multiple components or segments that collectively couple interconnect layers 101, 102. Some of vias 116, 236 are shown at FIG. 2B. Others of vias 116, 226, 236 are in front or behind viewing plane B-B'.

Vias 116, 226, 236 shown at FIG. 2A (though above viewing plane A-A') couple transistor structures 110 to a front-side interconnect network (e.g., various metal lines extending in the x-direction in layer 101). Drain regions are coupled to metallization layer 101 by front-side contacts 121 and vias 226. Gate structures 114 are coupled to metallization layer 101 by vias 116. Source regions are coupled to metallization layer 101 by front-side contacts 132 and vias 236.

Channel regions 111 extend in the x-direction between drain and source regions (under contacts 121, 132). Drain and source regions (under contacts 121, 132), isolation structures 140, and via structure 203 extend in the y-direction (perpendicular to the x-direction). Isolation structure 140 is between via structure 203 and source region and contacts 132, 133 of transistor structure 110A. Isolation structure 140 is between via structure 203 and source region and contacts 132, 133 of transistor structure 110B.

Via structure 203 extends in the y-direction between cells 200. Cells 200 are arranged similarly, but generally as reflections in the x-direction, across via structure 203. For example, transistor structures 110A, 110C are arranged similarly across via structure 203, and transistor structures 110B, 110D are arranged similarly across via structure 203. Notably, vias 116, 236 are not strictly reflected in the x-direction, across a y-axis of via structure 203.

Via structure 203 extends in the y-direction, parallel to isolation structures 140 and source regions (and contacts 132, 133). Via structure 203 is between, and parallel to, adjacent isolation structures 140. Isolation structures 140 are between via structure 203 and source regions (and contacts 132, 133). Pitch P₂ between drain and source regions (and respective contacts 121, 132) is approximately equal to pitch P₂ between via structure 203 and source regions (and contacts 132). Pitch P₂ between drain and source regions (and respective contacts 121, 132) is approximately equal to P₂ between adjacent isolation structures 140 (on either side of via structure 203). Pitch P₁ between gate structure 114 and either of drain and source regions (and respective contacts 121, 132) is approximately equal to P₁ between via structure 203 and isolation structures 140. A pair of isolation structures 140 (with via structure 203 therebetween) is between adjacent cells 200. For example, a pair of isolation structures 140 (with via structure 203 therebetween) is between adjacent transistor structures 110A, 110C (as shown on viewing plane B-B' of FIG. 2B) and between adj acent transistor structures 110B, 110D.

Though illustrated as a monolithic structure in FIG. 2A, via structure 203 shown as a single rectangle may be a series or array of via structures 203, e.g., in a row extending in the y-directions between isolation structures 140. Such an array of multiple via structures 203 may advantageously couple multiple metal lines in each of front- and back-side interconnect networks above and below cells 200. Such an array of multiple via structures 203 may advantageously couple multiple voltage sources (e.g., ground; voltage sources Vcc, Vss; etc.) and multiple source contacts 132, 133. Other similar via structures 203 (including series or arrays of via structures 203) may be to either side (e.g. in the x-directions), for example, extending in the y-direction adjacent the outer isolation structures 140 of FIG. 2A. Via structures 203 may serve multiple, adjacent (and other) cells 200. Via structure 203 may directly couple (e.g., contact) nearest layers 101, 102 and/or next-nearest layers in each of front- and back-side interconnect networks, e.g., to couple with metal lines extending in a desired direction (either x- or y-directions).

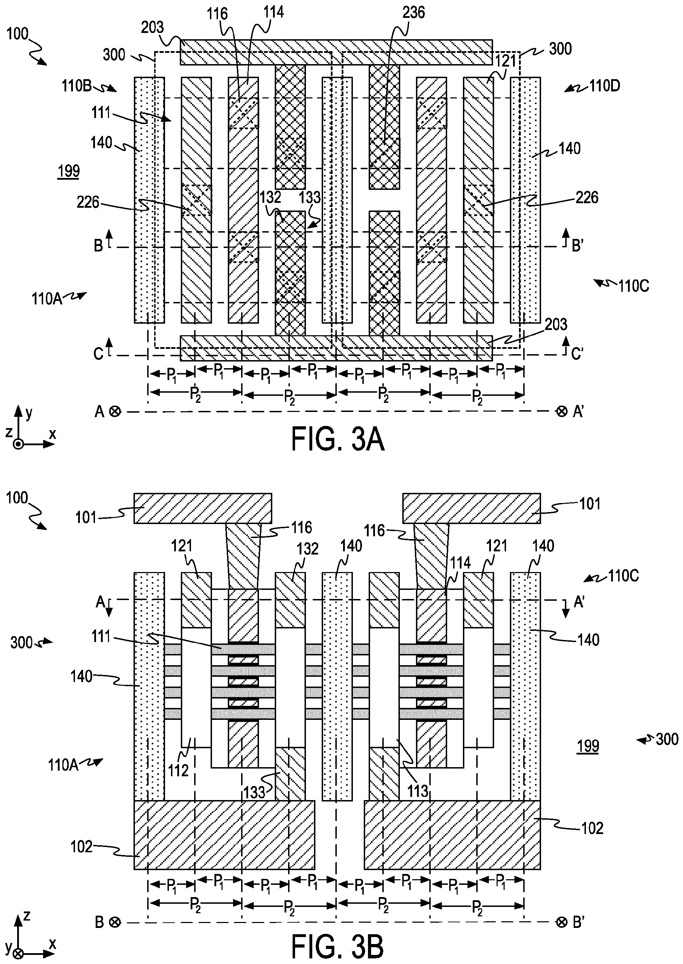

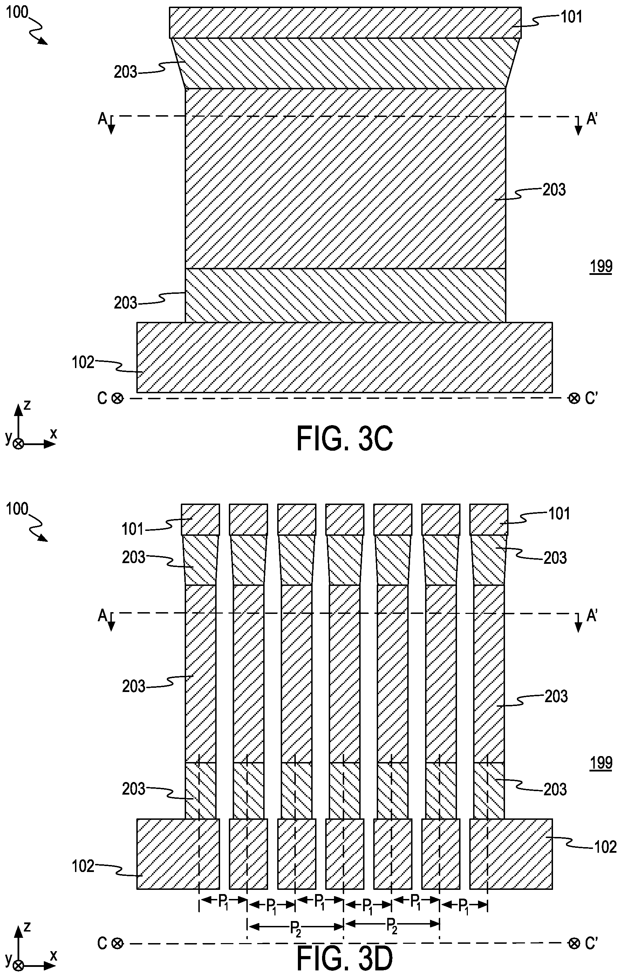

FIGS. 3A, 3B, 3C, and 3D illustrate cross-sectional profile and plan views of logic cells 300 between via structures 203, which are between and coupling interconnect layers 101, 102, in accordance with some embodiments. Notably, via structures 203 extend in the x-direction and are above or below (e.g., in either y-direction) corresponding transistor structures 110 of cells 300. Consequently, cells 300 may have different cell widths (e.g., in the x-direction) and heights (e.g., in the y-direction). Isolation structure 140 is between (and to both sides of) transistor structures 110. Dashed lines delineate cells 300 to each include multiple transistor structures 110 and isolation structure 140 between via structures 203. Dashed lines are also used to show, e.g., for illustrative purposes, features above viewing plane A-A' in FIG. 3A (such as vias 116, 226, 236 and the nanoribbons of channel regions 111). Dashed lines also show the locations of viewing plane B-B' (of FIG. 3B) and viewing plane C-C' (of FIGS. 3C and 3D) in FIG. 3A and of viewing plane A-A' (of FIG. 3A) in FIGS. 3B, 3C, and 3D. In the exemplary embodiments of FIGS. 3A, 3B, cells 300 are inverters, but other, more complex (e.g., having more inputs or more parallel legs) logic cells 300 may be deployed.

As with the embodiments of FIG. 2A, 2B, via structures 203 in cells 300 couple interconnect layers 101, 102 and may provide beneficially short electrical paths between front- and back-side contacts 132, 133 (or 121 and 124). Consistent (e.g., minimum) spacing of isolation structures 140, e.g., on pitches P₁, P₂, may enable the maintaining of layout arrays across many cells, the minimizing of the area costs spent on those cells, and the maximizing of a density of transistor structures 110 in IC device 100. Additionally, the availability of both cells 200, 300 (which have different lateral dimensions and aspect ratios) allow for design and layout flexibility, for example, to adjust logic array widths and lengths (e.g., in the x- and y-directions).

FIG. 3A shows a plan view of multiple cells 300 each having multiple transistor structures 110 adjacent and between via structures 203 and isolation structures 140. For example, transistor structures 110A, 110B are adjacent and between isolation structures 140 and via structures 203 in an inverter cell 300. Cells 300 are vertically between (e.g., in the z-direction) front- and back-side interconnect networks (not shown in FIG. 3A). Gate structures 114, source regions and contacts 132, 133, and drain regions and contacts 121 of transistor structures 110A, 110B, 110C, 110D are coupled similarly to the embodiments of FIGS. 2A, 2B (e.g., to layers 101, 102 and voltage sources Vcc, Vss, etc.), but with at least some notable differences. Notably, via structures 203 extend in the x-direction and are accessible to multiple cells 300. Source contacts 132, 133 in the y-directions and contact (and couple with) via structures 203 extending in the x-direction.

Also, with via structures 203 absent between transistor structures 110 (e.g., in the x-direction between transistor structures 110A, 110C and transistor structures 110B, 110D), and with the same pitch P₁ between adjacent regions, structures, contacts, etc., cells 300 may be deployed with a width less than the width of the embodiment of FIG. 2A. For example, in the x-direction, two cells 300 in FIG. 3A have a combined width equal to eight times pitch P₁ between edge structures 140 bordering the two cells, and two cells 200 in FIG. 2A have a combined width equal to ten times pitch P₁. (Such a width advantage is increased if the width of FIG. 2A includes another via structure to each side of cells 200.) Cells 200 are similarly shorter (in the y-direction) than cells 300. Cells 200, 300 may be deployed advantageously to minimize the desired dimension (e.g., in the x- or y-direction).

Multiple transistor structures 110 (e.g., adjacent transistor structures 110A, 110B or transistor structures 110C, 110D) are between first and second via structures 203 and between adjacent first and second isolation structures 140. Isolation structure 140 (e.g., between adjacent transistor structures 110A, 110C or transistor structures 110B, 110D) is between first and second via structures 203. Isolation structure 140 is between source regions and contacts 132, 133 of adjacent transistor structures 110A, 110C and between source regions and contacts 132, 133 of adjacent transistor structures 110B, 110D. Channel regions 111 extend in the x-direction between drain and source regions (under contacts 121, 132). First and second via structures 203 extend in the x-direction, substantially parallel to channel regions 111 and substantially perpendicular to isolation structures 140, which extend in the y-direction. Source regions and contacts 132, 133 extend in the y-direction, parallel to isolation structures 140. Source contacts 132, 133 of transistor structures 110A-110D are integrated, or in contact, with corresponding, adjacent via structures 203.

Though illustrated as monolithic structures in FIG. 3A, via structures 203 shown as single rectangles may each be a series or array of via structures 203, e.g., in a row extending in the x-directions above and below (in the y-direction) cells 300, as described at least at FIG. 3D. Such an array of multiple via structures 203 may advantageously couple multiple metal lines in each of front- and back-side interconnect networks above and below cells 200. Such an array of multiple via structures 203 may advantageously couple multiple voltage sources (e.g., ground; voltage sources Vcc, Vss; etc.) and multiple source contacts 132, 133.

FIG. 3B illustrates a cross-sectional profile view of cells 300 on either side of a central isolation structure 140 and between outer isolation structures 140, each cell 300 having transistor structures 110 adjacent and between isolation structures 140. Via structure 203 is absent between transistor structures 110. Consistent, minimum pitches P₁, P₂ are between adjacent regions, structures, contacts, etc. Viewing plane B-B' is parallel with via structure 203 and too deep into cells 300 (e.g., further in the positive y-direction) to show via structure 203. FIGS. 3C and 3D show example embodiments of via structure 203 at a viewing plane C-C' parallel to the viewing plane B-B' of FIG. 3B. Some of vias 116 are shown at FIG. 2B. Others of vias 116, 226, 236 are in front or behind viewing plane B-B'.

FIGS. 3C and 3D illustrate cross-sectional profile views (at viewing plane C-C') of different embodiments of via structures 203 in cells 300. Via structures 203 extend vertically (e.g., in the z direction) between first and second metallization layers 101, 102. Via structures 203 may directly couple (e.g., contact) nearest layers 101, 102 and/or next-nearest layers in each of front- and back-side interconnect networks, e.g., to couple with metal lines extending in a desired direction (either x- or y-directions).

FIG. 3C shows a substantially monolithic or unitary via structure 203 adjacent transistor structures 110 in cells 300. A large via structure 203 (e.g., having a large cross-sectional area, for example, due to being multiple line-widths wide) may enable the distribution of large currents (e.g., from a lower interconnect network dedicated to power delivery) to multiple separate smaller lines (e.g., in an upper interconnect network). Via structures 203, particularly large structures 203, may serve multiple, adjacent (and other) cells 300.

FIG. 3D illustrates an array of via structures 203 adjacent transistor structures 110 in cells 300. Via structures 203 are laid out with the same pitches P₁, P₂ as between adjacent regions, structures, contacts, etc., as shown in FIGS. 3A, 3B. An array of via structures 203 (in contrast to a sole, substantially monolithic via structure 203) may enable the coupling of multiple paired or complementary regions, structures, contacts, etc., over and under transistor structures 110. For example, multiple via structures 203 may be utilized to couple multiple pairs of front- and back-side source contacts 132, 133. Via structures 203 may couple nearest layers 101, 102 and/or next-nearest layers in each of front- and back-side interconnect networks, e.g., to couple with metal lines extending in a desired direction (either x- or y-directions).

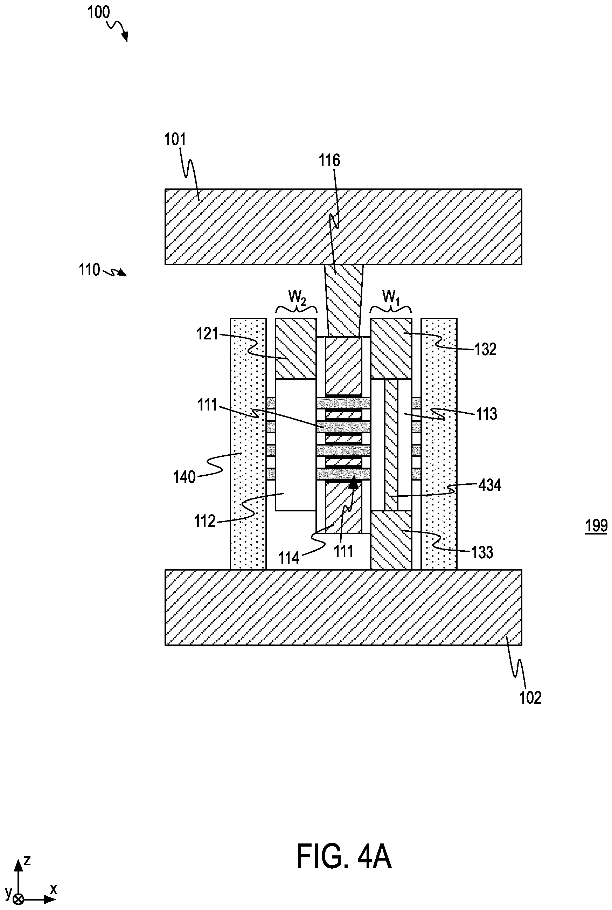

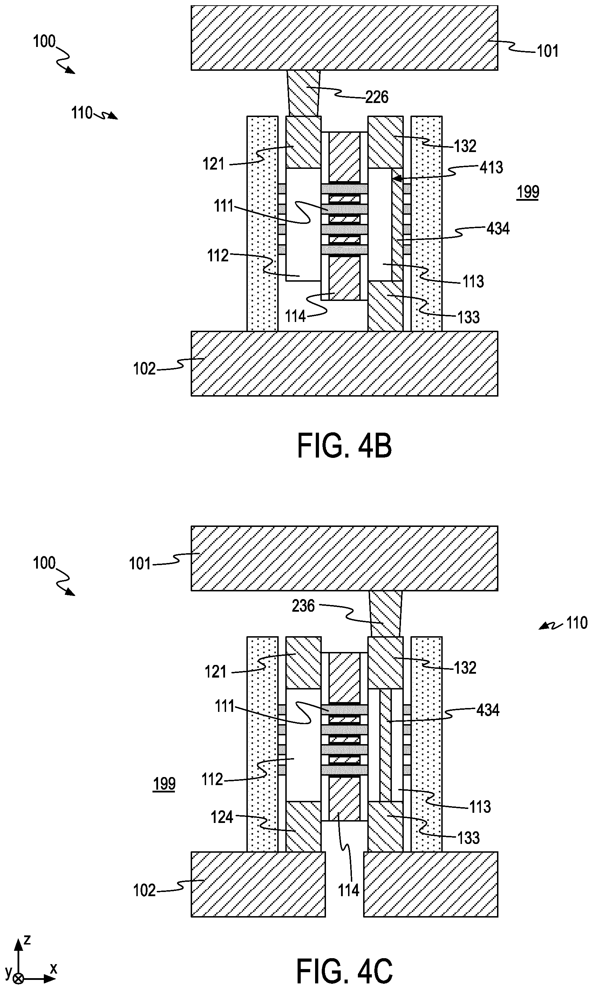

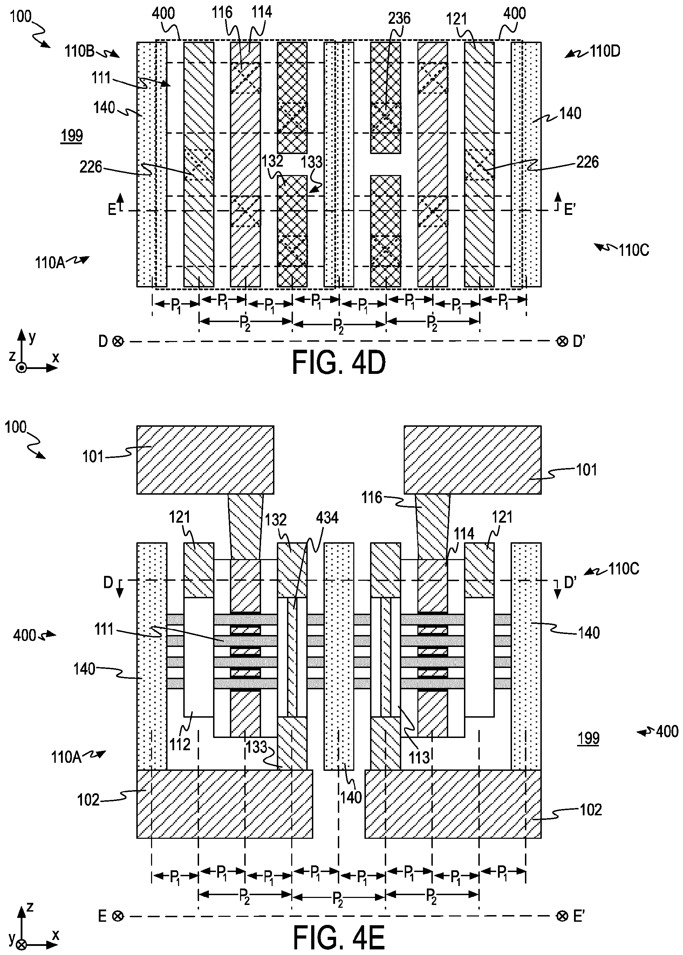

FIGS. 4A, 4B, 4C, 4D, and 4E illustrate cross-sectional profile and plan views of transistor structures 110 having via structures 434 through or alongside drain or source regions 112, 113, in accordance with some embodiments. Via structures 434 through or alongside source regions 113 may further improve contact resistance and, consequently, drive current. Via structures 434 between and coupling front- and back-side source contacts 132, 133 may be employed to couple front- and back-side interconnect networks (via layers 101, 102) within a footprint of transistor structures 110, which may enable further scaling down of, for example, logic cells. As previously described, reduced contact resistance on source regions 113 may have greater benefit than similarly reduced contact resistance on drain regions 112, but the improvements described for one of regions 112, 113 may be similarly implemented for the other of regions 112, 113. Via structures 434 may be deployed in either or both of regions 112, 113.

FIG. 4A shows transistor structure 110 between metallization layers 101, 102 (as part of associated metallization networks), much as described at least at FIG. 1A. For example, transistor structure 110 is coupled to layers 101, 102 by front-side contacts 121, 132 on and over drain and source regions 112, 113 and back-side contact 133 on and under source region 113. (Regions 112, 113 are coupled to layer 101 through contacts 121, 132 by off-viewing plane, not-shown vias, similar to gate via 116.) Notably, the embodiment of FIG. 4A includes via structure 434 that couples front- and back-side source contacts 132, 133. Via structure 434 includes a metallic material and is in contact with source region 113. In the embodiment of FIG. 4A, via structure 434 extends through source region 113 and directly contacts source contacts 132, 133. Via structure 434 extending through source region 113 may maximize performance (e.g., by minimizing source contact resistance, for example, relative to the embodiments of FIG. 4B).

In some embodiments, source region 113 with via structure 434 has a first width W₁ greater than a second width W₂ of drain region 112 (without via structure 434). The larger width W₁, may be to accommodate via structure 434 in source region 113 (e.g., to provide sufficient clearance mechanically in semiconductor region 113). In some embodiments, source region 113 with via structure 434 has width W₁ and drain region 112 (of the same transistor structure 110, but without via structure 434) has width W₁. In some such embodiments, an adjacent transistor structure 110 (not shown) without via structure 434 (e.g., without one of contacts 132 or 133) has drain and/or source regions 112, 113 with a third width less than width W₁. In some embodiments, drain and source regions 112, 113 have a same width W₁ (and source region 113 includes via structure 434 through region 113), and an adjacent transistor structure 110 (not shown) without via structure 434 (e.g., without one of contacts 132 or 133) has drain or source regions 112, 113 with third widths less than width W₁.

FIG. 4B illustrates transistor structure 110 between metallization layers 101, 102 (as part of associated metallization networks), much as described at least at FIG. 4A. Notably, in FIG. 4B, transistor structure 110 includes via structure 434 coupling front- and back-side source contacts 132, 133, via structure 434 extends alongside source region 113 (rather than through region 113). Via structure 434 extends along a sidewall 413 of source region 113. Via structure 434 directly contacts front- and back-side source contacts 132, 133. In the embodiment of FIG. 4B, via structure 434 is between source region 113 and the dielectric material of isolation structure 140 (or a dielectric material between source region 113 and isolation structure 140). In some embodiments, via structure 434 is between source region 113 and an adjacent drain or source region 112, 113. In some embodiments, via structure 434 is alongside a sidewall 413 of source region 113 and directly contacts sidewalls of source contacts 132, 133.

Via structure 434 extending alongside source region 113 may provide most (or at least much) of the performance benefits of the embodiments of FIG. 4A (e.g., by reducing source contact resistance) while minimizing processing difficulties and/or cost (e.g., relative to forming via structure 434 through a semiconductor region 113).

FIG. 4C shows transistor structure 110 between metallization layers 101, 102 (as part of associated metallization networks), much as described at least at FIG. 4A. Notably, the embodiment of FIG. 4C includes via structure 434 in or on source region 113 that couples front- and back-side source contacts 132, 133 and drain region 112 with front- and back-side drain contacts 121, 124 (but without a via structure 434 coupling contacts 121, 124). In some embodiments, a pair of adjacent transistor structures 110 includes a first transistor structure 110 with via structure 434 in or on source region 113 and coupling contacts 132, 133 and a second transistor structure 110 with via structure 434 in or on drain region 112 and coupling contacts 121, 124. Such via structures 434 may provide connections between layers 101, 102 for a pair of signals in parallel transistors or cells, for example, for a voltage source on parallel source regions 113 and for an output signal on parallel drain regions 112.

FIGS. 4D and 4E illustrate cross-sectional profile and plan views of logic cells 400, including transistor structures 110 having via structures 434 through or alongside source regions 113. Cells 400 may be similar to cells 200, 300, but cells 400 utilize via structures 434 through source regions 113, for example, instead of via structures 203 of cells 200, 300. Cells 400 may have a reduced footprint relative to cells 200, 300 due to the absence of via structures 203 between transistor structures 110.

For example, the plan view of FIG. 4D shows cells 400 having a reduced width (e.g., in the x-direction), similar to cells 300 at FIG. 3A, but also a reduced height (e.g., in the y-direction), similar to cells 200 at FIG. 2A. Isolation 140 (but no via structure 203) is between adjacent cells 400. For example, isolation structure 140 is between a first cell 400 (having first and second transistor structures 110A, 110B) and a second cell 400 (having third and fourth transistor structures 110C, 100D) with isolation structure 140 between transistor structures 110A, 110C and between transistor structures 110B, 110D.

The regions, structures, contacts, etc., of cells 400 are laid out with consistent pitches P₁, P₂., which may provide design and layout flexibility and enable increased device densities. For example, pitch P₂ between drain and source regions 112, 113 (under corresponding contacts 121, 132) is equal to both pitch P₂ between source regions 113 of first and third transistor structures 110A, 110C and to pitch P₂ between source regions 113 of second and fourth transistor structures 110B, 110D.

The cross-sectional profile view of FIG. 4E shows transistor structures 110 between interconnect layers 101, 102 and having via structures 434 through source regions 113, while via structures (e.g., structures 203) are absent between transistor structures 110.

Transistor structures 110 are between first and second metallization layers 101, 102. Multiple transistor structures 110 are between layers 101, 102. Front-side contacts 121, 132 contact drain and source regions 112, 113 and couple drain and source regions 112, 113 to first metallization layer 101. Back-side contacts 133 contact source regions 113 and couple source regions 113 to second metallization layer 102. Multiple via structures 434 contact and couple source regions 113 and contacts 132, 133. While via structures 434 contact source regions 113 and contacts 132, 133 by extending through regions 113, via structures 434 extend alongside sidewalls of regions 113 in some embodiments.

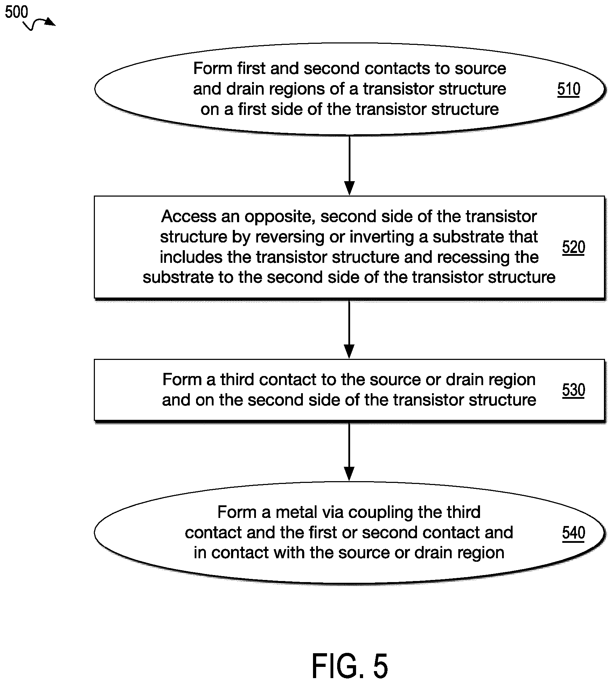

FIG. 5 is a flow chart of methods 500 for forming an IC device having front- and back-side interconnects and contacts to a transistor, in accordance with some embodiments. Methods 500 include operations 510-540. Some operations shown in FIG. 5 are optional. Additional operations may be included. FIG. 5 shows an example sequence, but the operations can be done in other orders as well, and some operations may be omitted. Some operations can also be performed multiple times before other operations are performed. For example, vias can be formed before inverting a substrate. Some operations may be included within other operations so that the number of operations illustrated FIG. 5 is not a limitation of the methods 500.

Methods 500 begin with forming source and drain contacts on a first side of a transistor structure at operation 510. Contacts may be formed by any suitable means. Contacts may be or include metal structures that contact and couple semiconductor regions, for example, epitaxially grown source and/or drain regions on ends of transistor channel regions. Forming contacts may include depositing metallic material on semiconductor material. In some embodiments, a semiconductor-metal alloy is formed, e.g., deposited or grown, on the semiconductor regions. In some such embodiments, further metal is formed on the alloy. The forming of metal on the semiconductor regions may include or be preceded by one or more contact etches, which may prepare the semiconductor regions (e.g., the semiconductor surface height or depth, shape, and finish) for metal deposition. Multiple contacts may be formed, for example, on a drain region and a source region, on opposite ends of one or more channel regions. The contacts may be formed on a first side of the transistor structure, which may be on an upper or front side of a substrate of or including semiconductor material (such as a wafer or die).

Methods 500 continue at operation 520 by accessing a second (e.g., back) side of the transistor structure opposite the first side. In some embodiments, the second side is accessed by inverting the substrate having the transistor structure. In some such embodiments, the substrate is recessed down to the second side. For example, a wafer that includes the transistor structure may be coupled to a carrier wafer (e.g., at the first (e.g., front) side of the substrate) and inverted so that the second (e.g., back) side of the substrate and transistor structure (opposite the first side) is accessed, available for further processing. The second side of the substrate may be recessed down to the second side of the transistor structure. Such recessing may be by any suitable means. For example, a wafer back-side may be ground away and down to near the transistor structure, and the wafer may then be finely polish down further, e.g., to expose any necessary structures of or adjacent the transistor structure. Other techniques, such as etching, can be used or deployed together with grinding and polishing,

Methods 500 continue by forming a contact on the second (e.g., back) side of the transistor structure at operation 530. In some embodiments, the back-side contact is formed on or to the source region of the transistor structure. The additional contact may provide a parallel contact to the first or front-side contact and so reduce the contact resistance. Although the benefits of such reduced contact resistance may be more significant for a transistor source region (than a drain region), back-side contacts may be formed on either or both source and drain regions. In some embodiments, the back-side contact is formed on or to the drain region of the transistor structure. In some embodiments, back-side contacts are formed on or to the source and drain regions.

Methods 500 continue at operation 540 with forming a via between contacts on the first and second sides of the transistor structure. Forming the via may couple front- and back-side contacts. In some embodiments, the via is formed between and after one or both of the contacts. In some embodiments, the via is formed before one or both of the contact, and one or both of the contacts is formed on the via. For example, the via may be formed before inverting a substrate, e.g., at operation 520. The via may be formed by any suitable means, e.g., with an anisotropic (e.g., deep, vertical) dry etch.

The via may be formed by opening a hole and depositing a metallic material in the hole, e.g., in contact with the source or drain region. In some embodiments, forming the via includes opening the hole through the source or drain region. In some embodiments, forming the via includes opening the hole through a dielectric material adjacent the source or drain region. The via may be formed by depositing the metallic material in a hole through the source or drain region or on a sidewall of the source or drain region, e.g., also on a dielectric material adjacent the source or drain region. The via between contacts on the first and second sides of the transistor structure may couple front- and back-side interconnect layers and networks over and under the transistor structure.

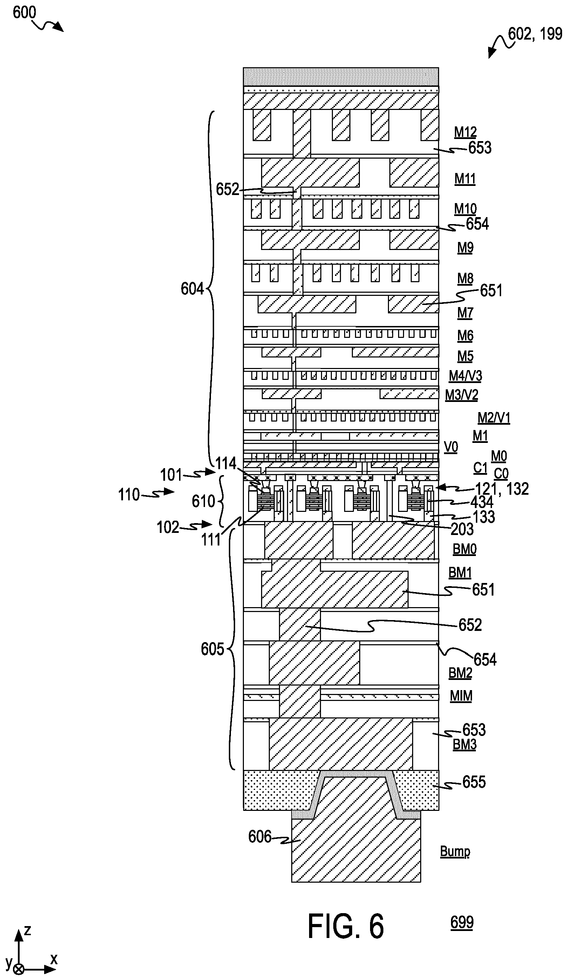

FIG. 6 illustrates a cross-sectional profile view of IC system 600 having front- and back-side contacts 121, 132, 133 and via structures 203 between interconnect layers 101, 102, in accordance with some embodiments. In the example of IC system 600, IC die 602 includes compact logic cells having interconnections between front-side layers 101, 604 and back-side layers 102, 605. IC system 600 includes a lateral surface along the x-y plane that may be defined or taken at any vertical position of IC system 600. The lateral surface of the x-y plane is orthogonal to a vertical or build-up dimension as defined by the z-axis. In some embodiments, IC system 600 may be formed from any substrate material suitable for the fabrication of transistor circuitry. In some embodiments, die 602 is a semiconductor substrate (such as described substrate 199) used to manufacture transistor structures 110 and other transistors and components of IC system 600. The semiconductor substrate may include a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as gallium arsenide. The substrate may also include semiconductor materials, metals, dielectrics, dopants, and other materials commonly found in semiconductor substrates.

In FIG. 6, IC system 600 includes an IC die 602, which is a monolithic IC with logic cells (such as cells 200, 300, or 400) as described above, including transistor structures 110 and via structures 203 (and/or 434), front-side metallization layers 101, 604 (or front-side interconnect layers), and optional back-side metallization layers 102, 605 (or back-side interconnect layers). As shown, transistor structures 110 are embedded within a dielectric layer 610. As shown, each transistor structure 110 includes channel regions 111 (e.g., within fins, nanosheets, or nanowires) and gate structures 114. Each of transistor structures 110 also include source and drain regions and source and drain contacts. In some embodiments, front-side metallization layers 604 provide signal routing to transistor structures 110 and back-side metallization layers 605 provide power delivery, as enabled by through-via structures 203, to transistor structures 110.

Interconnectivity of transistor structures 110 (and other transistors, etc.), signal routing to and from memory arrays, etc., power delivery, etc., and routing to an outside device (not shown), is provided by front-side metallization layers 604, back-side metallization layers 605, and package-level interconnects 606. In the example of FIG. 6, package-level interconnects 606 are provided on or over a back-side of IC die 602 as bumps over a passivation layer 655, and IC system 600 is attached to a substrate 699 (and coupled to signal routing, power delivery, etc.) by package-level interconnects 606. However, package-level interconnects 606 may be provided using any suitable interconnect structures such as bond pads, solder bumps, etc. Furthermore, in some embodiments, package-level interconnects 606 are provided on or over a front-side of IC die 602 (i.e., over front-side metallization layers 604).

As used herein, the term "metallization layer" describes layers with interconnections or wires that provide electrical routing, generally formed of metal or other electrically and thermally conductive material. Adjacent metallization layers may be formed of different materials and by different methods. Adjacent metallization layers, such as metallization interconnects 651, are interconnected by vias, such as vias 652, that may be characterized as part of the metallization layers or between the metallization layers. As shown, in some embodiments, front-side metallization layers 101, 604 are formed over and immediately adjacent transistor structures 110. The back-side is then the opposite side, which may be exposed during processing by attaching the front-side to a carrier wafer and exposing the back-side (e.g., by back-side grind or etch operations) as known in the art.

In the illustrated example, front-side metallization layers 604 include M0, V0, M1, M2/V1, M3/V2, M4/V3, and M4-M12. However, front-side metallization layers 604 may include any number of metallization layers such as eight or more metallization layers. Similarly, back-side metallization layers 605 include BM0, BM1, BM2, and BM3. However, back-side metallization layers 605 may include any number of metallization layers such as two to five metallization layers. Front-side metallization layers 604 and back-side metallization layers 605 are embedded within dielectric materials 653, 654. Furthermore, optional metal-insulator-metal (MIM) devices such as diode devices may be provided within back-side metallization layers 605. Other devices such as capacitive memory devices may be provided within front-side metallization layers 604 and/or back-side metallization layers 605.

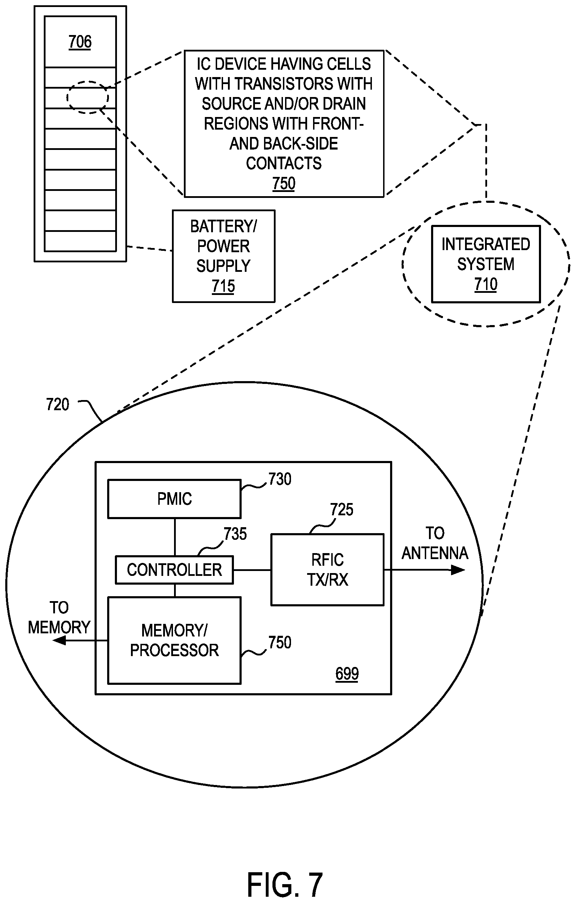

FIG. 7 illustrates a diagram of an example data server machine 706 employing an IC device having logic cells between front- and back-side interconnect layers and with front- and back-side contacts, in accordance with some embodiments. Server machine 706 may be any commercial server, for example, including any number of high-performance computing platforms disposed within a rack and networked together for electronic data processing, which in the exemplary embodiment includes one or more devices 750 having front- and back-side contacted logic cells between interconnect layers.

Also as shown, server machine 706 includes a battery and/or power supply 715 to provide power to devices 750, and to provide, in some embodiments, power delivery functions such as power regulation. Devices 750 may be deployed as part of a package-level integrated system 710. Integrated system 710 is further illustrated in the expanded view 720. In the exemplary embodiment, devices 750 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 750 is a microprocessor including a static RAM (SRAM) cache memory. As shown, device 750 may be an IC device having logic cells between front- and back-side interconnect layers and with front- and back-side contacts, as discussed herein. Device 750 may be further coupled to (e.g., communicatively coupled to) a board, an interposer, or a substrate 699 along with, one or more of a power management IC (PMIC) 730, RF (wireless) IC (RFIC) 725 including a wideband RF (wireless) transmitter and/or receiver (TX/RX) (e.g., including a digital baseband and an analog front end module further includes a power amplifier on a transmit path and a low noise amplifier on a receive path), and a controller 735 thereof. In some embodiments, RFIC 725, PMIC 730, controller 735, and device 750 include logic cells with front- and back-side contacts and between front- and back-side interconnect layers.

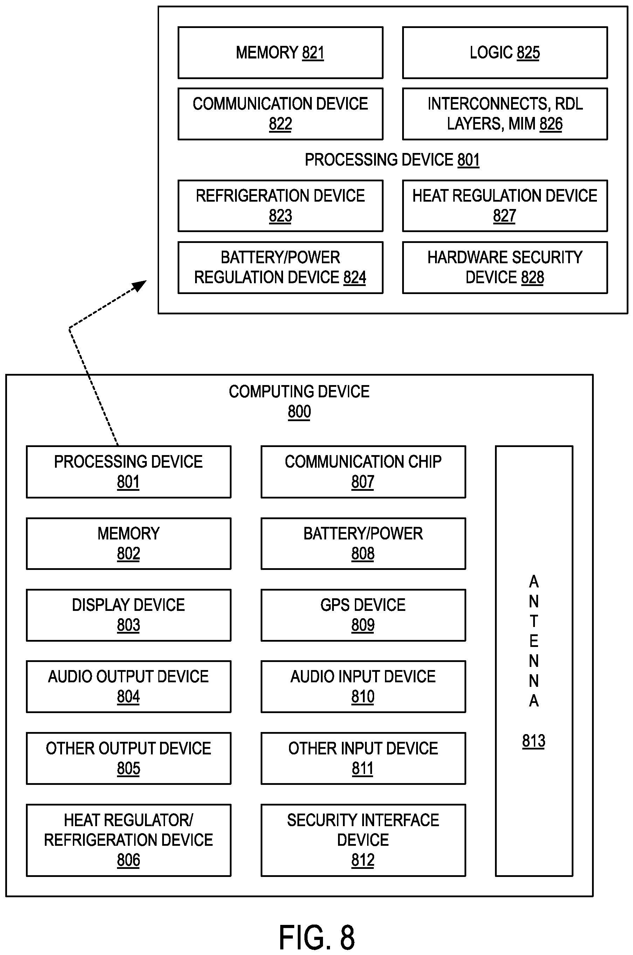

FIG. 8 is a block diagram of an example computing device 800, in accordance with some embodiments. For example, one or more components of computing device 800 may include any of the devices or structures discussed herein. A number of components are illustrated in FIG. 8 as being included in computing device 800, but any one or more of these components may be omitted or duplicated, as suitable for the application. In some embodiments, some or all of the components included in computing device 800 may be attached to one or more printed circuit boards (e.g., a motherboard). In some embodiments, various ones of these components may be fabricated onto a single system-on-a-chip (SoC) die. Additionally, in various embodiments, computing device 800 may not include one or more of the components illustrated in FIG. 8, but computing device 800 may include interface circuitry for coupling to the one or more components. For example, computing device 800 may not include a display device 803, but may include display device interface circuitry (e.g., a connector and driver circuitry) to which display device 803 may be coupled. In another set of examples, computing device 800 may not include an audio output device 804, other output device 805, global positioning system (GPS) device 809, audio input device 810, or other input device 811, but may include audio output device interface circuitry, other output device interface circuitry, GPS device interface circuitry, audio input device interface circuitry, audio input device interface circuitry, to which audio output device 804, other output device 805, GPS device 809, audio input device 810, or other input device 811 may be coupled.

Computing device 800 may include a processing device 801 (e.g., one or more processing devices). As used herein, the term "processing device" or "processor" indicates a device that processes electronic data from registers and/or memory to transform that electronic data into other electronic data that may be stored in registers and/or memory. Processing device 801 may include a memory 821, a communication device 822, a refrigeration device 823, a battery/power regulation device 824, logic 825, interconnects 826 (i.e., optionally including redistribution layers (RDL) or metal-insulator-metal (MIM) devices), a heat regulation device 827, and a hardware security device 828.

Processing device 801 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 800 may include a memory 802, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 802 includes memory that shares a die with processing device 801. This memory may be used as cache memory and may include embedded dynamic random-access memory (eDRAM) or spin transfer torque magnetic random-access memory (STT-MRAM).

Computing device 800 may include a heat regulation/refrigeration device 806. Heat regulation/refrigeration device 806 may maintain processing device 801 (and/or other components of computing device 800) at a predetermined low temperature during operation.

In some embodiments, computing device 800 may include a communication chip 807 (e.g., one or more communication chips). For example, the communication chip 807 may be configured for managing wireless communications for the transfer of data to and from computing device 800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 807 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 807 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 807 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 807 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 807 may operate in accordance with other wireless protocols in other embodiments. Computing device 800 may include an antenna 813 to facilitate wireless communications and/or to receive other wireless communications (such as AM or FM radio transmissions).

In some embodiments, communication chip 807 may manage wired communications, such as electrical, optical, or any other suitable communication protocols (e.g., the Ethernet). As noted above, communication chip 807 may include multiple communication chips. For instance, a first communication chip 807 may be dedicated to shorter-range wireless communications such as Wi-Fi or Bluetooth, and a second communication chip 807 may be dedicated to longer-range wireless communications such as GPS, EDGE, GPRS, CDMA, WiMAX, LTE, EV-DO, or others. In some embodiments, a first communication chip 807 may be dedicated to wireless communications, and a second communication chip 807 may be dedicated to wired communications.

Computing device 800 may include battery/power circuitry 808. Battery/power circuitry 808 may include one or more energy storage devices (e.g., batteries or capacitors) and/or circuitry for coupling components of computing device 800 to an energy source separate from computing device 800 (e.g., AC line power).

Computing device 800 may include a display device 803 (or corresponding interface circuitry, as discussed above). Display device 803 may include any visual indicators, such as a heads-up display, a computer monitor, a projector, a touchscreen display, a liquid crystal display (LCD), a light-emitting diode display, or a flat panel display, for example.

Computing device 800 may include an audio output device 804 (or corresponding interface circuitry, as discussed above). Audio output device 804 may include any device that generates an audible indicator, such as speakers, headsets, or earbuds, for example.

Computing device 800 may include an audio input device 810 (or corresponding interface circuitry, as discussed above). Audio input device 810 may include any device that generates a signal representative of a sound, such as microphones, microphone arrays, or digital instruments (e.g., instruments having a musical instrument digital interface (MIDI) output).

Computing device 800 may include a GPS device 809 (or corresponding interface circuitry, as discussed above). GPS device 809 may be in communication with a satellite-based system and may receive a location of computing device 800, as known in the art.

Computing device 800 may include other output device 805 (or corresponding interface circuitry, as discussed above). Examples of the other output device 805 may include an audio codec, a video codec, a printer, a wired or wireless transmitter for providing information to other devices, or an additional storage device.

Computing device 800 may include other input device 811 (or corresponding interface circuitry, as discussed above). Examples of the other input device 811 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 800 may include a security interface device 812. Security interface device 812 may include any device that provides security measures for computing device 800 such as intrusion detection, biometric validation, security encode or decode, access list management, malware detection, or spyware detection.

Computing device 800, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1-8. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, one or more logic cells includes a transistor structure between first and second metallization layers, the transistor structure including a channel region between and coupling source and drain regions, a gate electrode adjacent the channel region, wherein a first metal structure contacts a first of the source and drain regions, a second of the source and drain regions is between and contacts second and third metal structures, the first and second metal structures are coupled to the first metallization layer, and the third metal structure is coupled to the second metallization layer, an isolation structure adjacent and substantially parallel to the second of the source and drain regions, wherein a pitch between the source and drain regions is approximately equal to the pitch between the isolation structure and the gate electrode, and a via structure adjacent the isolation structure and the second of the source and drain regions, the via structure extending vertically between the first and second metallization layers and including a first metallic material.

In one or more second embodiments, further to the first embodiments, the first of the source and drain regions is between a fourth metal structure and the first metal structure, and the first of the source and drain regions is coupled by the fourth metal structure to the second metallization layer.

In one or more third embodiments, further to the first or second embodiments, the via structure is substantially parallel to the isolation structure and the second of the source and drain regions, the isolation structure is between the via structure and the second of the source and drain regions, and the pitch between the source and drain regions is approximately equal to the pitch between the via structure and the second of the source and drain regions.

In one or more fourth embodiments, further to the first through third embodiments, the transistor structure is a first transistor structure, also including a second transistor structure adjacent the isolation structure, the second transistor structure including a second gate structure and a second source structure, wherein the gate electrode and the second gate structure are coupled, the second source structure is coupled to the first and second metallization layers, the source region is coupled to a first voltage source, the second source structure is coupled to a second voltage source, the channel region extends in a first direction between the source and drain regions, the isolation structure, the first via structure, the source region, and the second source structure extend in a second direction substantially perpendicular to the first direction, and

In one or more fifth embodiments, further to the first through fourth embodiments, the transistor structure is a first transistor structure, and the isolation structure is a first isolation structure, also including a second isolation structure and a second transistor structure adjacent the second isolation structure, wherein the first via structure is between the first and second isolation structures, and the second isolation structure is between the first via structure and the second transistor structure.

In one or more sixth embodiments, further to the first through fifth embodiments, the pitch between the source and drain regions is approximately equal to the pitch between the via structure and the second of the source and drain regions, and the pitch between the source and drain regions is approximately equal to the pitch between the first and second isolation structures. 7 the second via structure includes a second metallic material, extends substantially vertically between the first and second metallization layers, and couples the first and second metallization layers, the gate electrode and the second gate structure are coupled,

In one or more seventh embodiments, further to the first through sixth embodiments, the via structure is a first via structure, and the transistor structure is a first transistor structure, also including a second via structure adjacent the isolation structure and a second transistor structure adjacent the second via structure and the isolation structure, the second transistor structure including a second gate structure and a second source structure, wherein the second via structure includes a second metallic material, extends substantially vertically between the first and second metallization layers, and couples the first and second metallization layers, the gate electrode and the second gate structure are coupled, the second source structure is coupled to the first and second metallization layers, the source region is coupled to a first voltage source, the second source structure is coupled to a second voltage source, the channel region extends in a first direction between the source and drain regions,

In one or more eighth embodiments, further to the first through seventh embodiments, the second or third metal structure is integrated, or in contact, with the first via structure, and the second source structure is contacted above and below by fifth and sixth metal structures integrated, or in contact, with the second via structure. 9 the third and fourth source structures are parallel to the isolation structure, the isolation structure is between the source region and the third source structure,

In one or more ninth embodiments, a first cell includes the first and second transistor structures, also including a second cell including third and fourth transistor structures and third and fourth source structures adjacent the isolation structure, wherein the third and fourth source structures are parallel to the isolation structure, the isolation structure is between the source region and the third source structure, the isolation structure is between the second and fourth source structures, the source region and the third source structure are coupled with the first via structure, and the second and fourth source structures are coupled with the second via structure.

In one or more tenth embodiments, further to the ninth embodiments, an apparatus includes first and second metallization networks, and a transistor structure between the first and second metallization networks, the transistor structure including first and second impurity doped regions and a channel region therebetween, wherein the first impurity doped region is coupled by a first metal structure to the first metallization network over the transistor structure, the second impurity doped region is coupled by a second metal structure to the first metallization network and by a third metal structure to the second metallization network under the transistor structure, and a first via couples the second and third metal structures, the first via including a metallic material in contact with the second impurity doped region.

In one or more eleventh embodiments, further to the ninth or tenth embodiments, the first via extends through the second impurity doped region and directly contacts the second and third metal structures.

In one or more twelfth embodiments, further to the ninth through eleventh embodiments, the second impurity doped region has a first width greater than a second width of the first impurity doped region.

In one or more thirteenth embodiments, further to the ninth through twelfth embodiments, the transistor structure is a first transistor structure, also including a second transistor structure including third and fourth impurity doped regions and fourth and fifth metal structures, the third impurity doped region coupled by the fourth metal structure to the first or second metallization network and the fourth impurity doped region coupled by the fifth metal structure to the first or second metallization network, wherein the first width of the second impurity doped region is greater than a third width of the third or fourth impurity doped region.

In one or more fourteenth embodiments, further to the ninth through thirteenth embodiments, the first via extends along a sidewall of the second impurity doped region, directly contacts the second and third metal structures, and is between the second impurity doped region and either a third impurity doped region or a dielectric material.

In one or more fifteenth embodiments, further to the ninth through fourteenth embodiments, the apparatus also includes a fourth metal structure, wherein the first impurity doped region is between and in contact with the first and fourth metal structures, and the first impurity doped region is coupled by the fourth metal structure to the second metallization network.

In one or more sixteenth embodiments, further to the ninth through fifteenth embodiments, the apparatus also includes a second via coupling the first and fourth metal structures, the second via including a metallic material in contact with the first impurity doped region.

In one or more seventeenth embodiments, one or more logic cells includes first and second metallization layers, a plurality of transistor structures between the first and second metallization layers, individual transistor structures including corresponding source and drain regions, wherein a plurality of first metal structures contact the source and drain regions and couple the source and drain regions to the first metallization layer, a plurality of second metal structures contact the source regions and couple the source regions to the second metallization layer, and a plurality of via structures couple corresponding first and second metal structures and contact corresponding source regions.

In one or more eighteenth embodiments, further to the seventeenth embodiments, a first cell includes a first and a second of the transistor structures, a second cell includes a third and a fourth of the transistor structures, and an isolation structure is between the first and the third of the transistor structures and between the second and the fourth of the transistor structures.

In one or more nineteenth embodiments, further to the seventeenth or eighteenth embodiments, a pitch between corresponding source and drain regions is approximately equal to a pitch between a first source region of the first of the transistor structures and a third source region of the third of the transistor structures, and a pitch between a second source region of the second of the transistor structures and a fourth source region of the fourth of the transistor structures.

In one or more twentieth embodiments, further to the seventeenth through nineteenth embodiments, a first of the via structures extends through a first of the source regions and contacts the corresponding first and second metal structures contacting the first of the source regions.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An integrated circuit (IC) structure, comprising:
a transistor structure between first and second metallization layers, the transistor structure comprising a channel region between and coupling source and drain regions, a gate electrode adjacent the channel region, wherein a first metal structure contacts a first of the source and drain regions, a second of the source and drain regions is between and contacts second and third metal structures, the first and second metal structures are coupled to the first metallization layer, and the third metal structure is coupled to the second metallization layer; an isolation structure adjacent and substantially parallel to the second of the source and drain regions, wherein a pitch between the source and drain regions is approximately equal to the pitch between the isolation structure and the gate electrode; and
a via structure adjacent the isolation structure and the second of the source and drain regions, the via structure extending vertically between the first and second metallization layers and comprising a metallic material.

2. The IC structure of claim 1, wherein the first of the source and drain regions is between a fourth metal structure and the first metal structure, and the first of the source and drain regions is coupled by the fourth metal structure to the second metallization layer.

3. The IC structure of either claim 1 or 2, wherein the via structure is substantially parallel to the isolation structure and the second of the source and drain regions, the isolation structure is between the via structure and the second of the source and drain regions, and the pitch between the source and drain regions is approximately equal to the pitch between the via structure and the second of the source and drain regions.

4. The IC structure of any one of claims 1-3, wherein the transistor structure is a first transistor structure, further comprising a second transistor structure adjacent the isolation structure, the second transistor structure comprising a second gate structure and a second source structure, wherein:
the gate electrode and the second gate structure are coupled;
the second source structure is coupled to the first and second metallization layers;
the second of the source and drain regions is coupled to a first voltage source;
the second source structure is coupled to a second voltage source;
the channel region extends in a first direction between the source and drain regions;
the isolation structure, the via structure, the second of the source and drain regions, and the second source structure extend in a second direction substantially perpendicular to the first direction; and
the isolation structure is between the via structure and the second of the source and drain regions and between the via structure and the second source structure.

5. The IC structure of any one of claims 1-4, wherein the transistor structure is a first transistor structure, and the isolation structure is a first isolation structure, further comprising a second isolation structure and a second transistor structure adjacent the second isolation structure, wherein the via structure is between the first and second isolation structures, and the second isolation structure is between the via structure and the second transistor structure.

6. The IC structure of claim 5, wherein:
the pitch between the source and drain regions is approximately equal to the pitch between the via structure and the second of the source and drain regions; and
the pitch between the source and drain regions is approximately equal to the pitch between the first and second isolation structures.

7. The IC structure of any one of claims 1-6, wherein the via structure is a first via structure, the metallic material is a first metallic material, and the transistor structure is a first transistor structure, further comprising a second via structure adjacent the isolation structure and a second transistor structure adjacent the second via structure and the isolation structure, the second transistor structure comprising a second gate structure and a second source structure, wherein:
the second via structure comprises a second metallic material, extends substantially vertically between the first and second metallization layers, and couples the first and second metallization layers;
the gate electrode and the second gate structure are coupled;
the second source structure is coupled to the first and second metallization layers;
the second of the source and drain regions is coupled to a first voltage source;
the second source structure is coupled to a second voltage source;
the channel region extends in a first direction between the source and drain regions;
the first and second via structures extend in the first direction, substantially parallel to the channel region and substantially perpendicular to the isolation structure; and
the first and second transistor structures and the isolation structure are between the first and second via structures.

8. The IC structure of claim 7, wherein:
the second or third metal structure is integrated, or in contact, with the first via structure; and
the second source structure is contacted above and below by fifth and sixth metal structures integrated, or in contact, with the second via structure.

9. The IC structure of either claim 7 or 8, wherein a first cell comprises the first and second transistor structures, further comprising a second cell comprising third and fourth transistor structures and third and fourth source structures adjacent the isolation structure, wherein:
the third and fourth source structures are parallel to the isolation structure;
the isolation structure is between the second of the source and drain regions and the third source structure;
the isolation structure is between the second and fourth source structures;
the second of the source and drain regions and the third source structure are coupled with the first via structure; and
the second and fourth source structures are coupled with the second via structure.

10. The IC structure of any one of claims 1-9, wherein the via structure couples the second and third metal structures, the metallic material in contact with the second of the source and drain regions.

11. The IC structure of claim 10, wherein the via structure extends through the second of the source and drain regions and directly contacts the second and third metal structures.

12. The IC structure of either claim 10 or 11, wherein the second of the source and drain regions has a first width greater than a second width of the first of the source and drain regions.

13. The IC structure of claim 12, wherein the transistor structure is a first transistor structure, further comprising a second transistor structure comprising third and fourth source and drain regions and fourth and fifth metal structures, the third of the source and drain regions coupled by the fourth metal structure to the first or second metallization layer and the fourth of the source and drain regions coupled by the fifth metal structure to the first or second metallization layer, wherein the first width of the second of the source and drain regions is greater than a third width of the third or fourth of the source and drain regions.

14. The IC structure of any one of claims 10-13, wherein the via structure:
extends along a sidewall of the second of the source and drain regions;
directly contacts the second and third metal structures; and
is between the second of the source and drain regions and either a third of the source and drain regions or a dielectric material.

15. The IC structure of any one of claims 10-14, wherein the via structure is a first via structure, and the metallic material is a first metallic material, further comprising a fourth metal structure and a second via structure coupling the first and fourth metal structures, the first of the source and drain regions between and in contact with the first and fourth metal structures and coupled by the fourth metal structure to the second metallization layer, the second via structure comprising a second metallic material in contact with the first of the source and drain regions.
